# EUROPEAN PATENT SPECIFICATION

(11) **EP 2 383 363 B1**
(45) Date of publication and mention of the grant of the patent: **13.01.2016**
(21) Application number: 11163296.4
(22) Date of filing: 20.04.2011
(51) Int. Cl.: C23C 14/06, C23C 14/34, H01L 31/0296, H01L 31/18, H01L 31/073

(54) **Cadmium sulfide layers for use in cadmium telluride based thin film photovoltaic devices and method of their manufacture**
Cadmiumsulfidschichten zur Verwendung in Cadmiumtellurid-basierten Dünnfilmfotovoltaikvorrichtungen und Herstellungsverfahren dafür
Couches de sulfure de cadmium pour dispositifs photovoltaïques à couche mince en tellurure de cadmium et leur procédé de fabrication

(30) Priority: 29.04.2010 US 770078
(43) Date of publication of application: 02.11.2011
(73) Proprietor: First Solar Malaysia SDN.BHD, Aman (MY)
(72) Inventor: Gossman, Robert Dwayne, Arvada, CO 80004 (US); Pavol, Mark Jeffrey, Arvada, CO 80004 (US)
(74) Representative: Thurston, Joanna

(56) References cited:
- WO-A2-2006/085348
- US-B1- 7 943 415
- PODESTA ET AL: "Influence of the fluorine doping on the optical properties of CdS thin films for photovoltaic applications", THIN SOLID FILMS, ELSEVIER-SEQUOIA S.A. LAUSANNE, CH, vol. 511-512, 26 July 2006 (2006-07-26), pages 448-452, XP005444887, ISSN: 0040-6090, DOI: 10.1016/J.TSF.2005.11.069
- EMZIANE M ET AL: "In situ oxygen incorporation and related issues in CdTe/CdS photovoltaic devices", JOURNAL OF APPLIED PHYSICS, AMERICAN INSTITUTE OF PHYSICS. NEW YORK, US, vol. 100, no. 1, 10 July 2006 (2006-07-10) , pages 13513-013513, XP012088844, ISSN: 0021-8979, DOI: 10.1063/1.2209788

## Description

### FIELD OF THE INVENTION

The subject matter disclosed herein relates generally to cadmium sulfide thin film layers and their methods of deposition. More particularly, the subject matter disclosed herein relates to cadmium sulfide layers for use in cadmium telluride thin film photovoltaic devices and their methods of manufacture.

### BACKGROUND OF THE INVENTION

Thin film photovoltaic (PV) modules (also referred to as "solar panels") based on cadmium telluride (CdTe) paired with cadmium sulfide (CdS) as the photo-reactive components are gaining wide acceptance and interest in the industry. CdTe is a semiconductor material having characteristics particularly suited for conversion of solar energy to electricity. For example, CdTe has an energy bandgap of about 1.45 eV, which enables it to convert more energy from the solar spectrum as compared to lower bandgap semiconductor materials historically used in solar cell applications (e.g., about 1.1 eV for silicon). Also, CdTe converts radiation energy in lower or diffuse light conditions as compared to the lower bandgap materials and, thus, has a longer effective conversion time over the course of a day or in cloudy conditions, as compared to other conventional materials. The junction of the n-type layer and the p-type layer is generally responsible for the generation of electric potential and electric current when the CdTe PV module is exposed to light energy, such as sunlight. Specifically, the cadmium telluride (CdTe) layer and the cadmium sulfide (CdS) layer form a p-n heterojunction, where the CdTe layer acts as a p-type layer (i.e., a positive, electron accepting layer) and the CdS layer acts as a n-type layer (i.e., a negative, electron donating layer).

The cadmium sulfide layer is a "window layer" in the photovoltaic device since light energy passes through it into the cadmium telluride layer. However, the optical bandgap of cadmium sulfide of about 2.42 eV limits the amount of radiation that can pass through the cadmium sulfide layer in the blue through ultraviolet. Thus, the radiation reaching the cadmium telluride layer is reduced in the higher energy region, resulting in otherwise available radiation energy being absorbed and/or reflected instead of converting to electrical current in the cadmium telluride layer.

As such, a need exists for shifting and/or expanding the optical bandgap of the cadmium sulfide layer, especially in the higher energy region (e.g., the blue to ultraviolet wavelengths), in order to increase the output of a cadmium telluride based thin film photovoltaic device.

PODESTA ET AL: "Influence of the fluorine doping on the optical properties of CdS thin films for photovoltaic applications", THIN SOLID FILMS, ELSEVIER-SEQUOIA S.A. LAUSANNE, CH, vol. 511-512, (2006-07-26), pages 448-452, describes a method of producing or doping a CdS layer with fluorine, by sputtering in a reactive atmosphere of Ar + CHF3 to produce fluoride ions.

EMZIANE M ET AL: "In situ oxygen incorporation and related issues in CdTe/CdS photovoltaic devices", JOURNAL OF APPLIED PHYSICS, AMERICAN INSTITUTE OF PHYSICS. NEW YORK, US, vol. 100, no. 1, (2006-07-10), pages 13513-013513, also describes a method of producing or doping a CdS layer with fluorine, by sputtering in a reactive atmosphere of Ar + CHF3 and then F- and further introduction of oxygen in the CdS/CdTe structure.

WO 2006/085348 discloses a process for the large-scale production of CdTe/CdS thin film solar cells, said films being deposited as a sequence on a transparent substrate, comprising the steps of: depositing a film of a transparent conductive oxide (TCO) on said substrate; depositing a film of CdS on said TCO film; depositing a film of CdTe on said CdS film; treating said CdTe film with a chlorine-containing inert gas; depositing a back-contact film on said treated CdTe film. The chlorine-containing inert gas is chlorofluorocarbon or a hydrochlorofluorocarbon product and the treatment is carried out in a vacuum chamber at an operating temperature of 380-420°C. The chlorine released as a result of the thermal dissociation of the product reacts with solid CdTe present on the cell surface to produce TeCl and CdCl vapors. Any residual CdCl is removed from the cell surface by applying vacuum to the vacuum chamber while keeping the temperature at the operating value.

### BRIEF DESCRIPTION OF THE INVENTION

Aspects and advantages of the invention will be set forth in part in the following description, or may be obvious from the description, or may be learned through practice of the invention.

The method of this invention is described in claim 1.

A Cadmium telluride based thin film photovoltaic device is described in claim 10.

These and other features, aspects and advantages of the present invention will become better understood with reference to the following description and appended claims.

The accompanying drawings, which are incorporated in and constitute a part of this specification, illustrate embodiments of the invention and, together with the description, serve to explain the principles of the invention.

### BRIEF DESCRIPTION OF THE DRAWING

A full and enabling disclosure of the present invention, including the best mode thereof, directed to one of ordinary skill in the art, is set forth in the specification, which makes reference to the appended figures, in which:
Fig. 1 shows a general schematic of a cross-sectional view of an exemplary cadmium telluride thin film photovoltaic device;
Fig. 2 shows a general schematic of a cross-sectional view of an exemplary cadmium telluride thin film photovoltaic device according to the present invention;

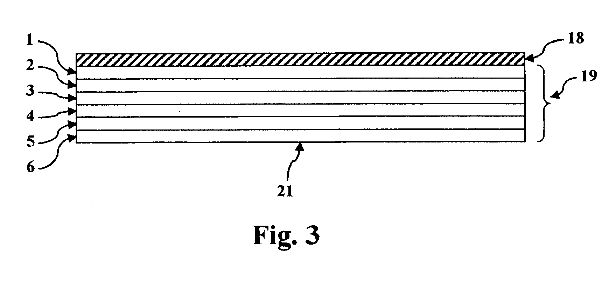

Fig. 3 shows a general schematic of a cross-sectional view of an exemplary cadmium sulfide layer and a second cadmium sulfide layer formed by a plurality of graded layers;
Fig. 4 shows a general schematic of a cross-sectional view of an exemplary cadmium sulfide layer and a second cadmium sulfide layer formed by a plurality of graded layers shows a general schematic of a cross-sectional view of an exemplary DC sputtering chamber according to one embodiment of the present invention; and,
Fig. 5 shows a flow diagram of an exemplary method of manufacturing a photovoltaic module including a cadmium telluride thin film photovoltaic device.

Repeat use of reference characters in the present specification and drawings is intended to represent the same or analogous features or elements.

### DETAILED DESCRIPTION OF THE INVENTION

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope of the invention. For instance, features illustrated or described as part of one embodiment can be used with another embodiment to yield a still further embodiment. Thus, it is intended that the present invention covers such modifications and variations as come within the scope of the appended claims and their equivalents.

In the present disclosure, when a layer is being described as "on" or "over" another layer or substrate, it is to be understood that the layers can either be directly contacting each other or have another layer or feature between the layers. Thus, these terms are simply describing the relative position of the layers to each other and do not necessarily mean "on top of since the relative position above or below depends upon the orientation of the device to the viewer. Additionally, although the invention is not limited to any particular film thickness, the term "thin" describing any film layers of the photovoltaic device generally refers to the film layer having a thickness less than about 10 micrometers ("microns" or "µm").

It is to be understood that the ranges and limits mentioned herein include all ranges located within the prescribed limits (i.e., subranges). For instance, a range from about 100 to about 200 also includes ranges from 110 to 150, 170 to 190, 153 to 162, and 145.3 to 149.6. Further, a limit of up to about 7 also includes a limit of up to about 5, up to 3, and up to about 4.5, as well as ranges within the limit, such as from about 1 to about 5, and from about 3.2 to about 6.5.

Generally speaking, devices and methods are disclosed for fluorine doped cadmium sulfide layers, particularly those cadmium sulfide layers included in a cadmium telluride based thin film device. Doping a cadmium sulfide layer with fluorine can cause the optical bandgap to shift to include higher energy radiation (such as blue and ultraviolet radiation). Thus, a cadmium sulfide layer doped with fluorine can allow more light to enter the cadmium telluride layer for conversion to electrical current, resulting in a more efficient photovoltaic device. Additionally, fluorine can increase the n-doping of the cadmium sulfide layer, which may allow for cadmium sulfide layers having a reduced thickness in the device while still achieving the same or improved effectiveness.

The addition of fluorine to the cadmium sulfide layer may result in the formation of cadmium fluoride (CdF₂) within the structure of the cadmium sulfide layer. The amount of fluorine included in the cadmium sulfide layer can be varied according to the desired optical bandgap shift. In most embodiments, the molar percentage of fluorine in the cadmium sulfide layer can be greater than 0% to about 5%, such as about 1 % to about 4%. If more than about 5 molar % of fluorine is included in the cadmium sulfide layer, then the layer may become too insulating, and adversely affect the performance of the resulting photovoltaic device.

The fluorine is supplied from an inorganic fluorine source gas present during the deposition of the cadmium sulfide layer. For example, when the cadmium sulfide layer is sputtered from a cadmium sulfide target, the inorganic fluorine source gas is included in the sputtering atmosphere, such as at an inorganic fluorine source gas concentration greater than 0% to about 15% by volume of the sputtering atmosphere (e.g., from about 1% to about 10% by volume). If too much fluorine source gas is present, the fluorine may remove (e.g., etch) the substrate or other layers instead of depositing fluorine. The remaining percentage of the sputtering atmosphere may include inert gas(es), such as argon, with or without the presence of oxygen in the sputtering atmosphere (e.g., up to about 15% by volume).

Sputtering deposition involves ejecting material from a target, which is the material source, and depositing the ejected material onto the substrate to form the film. DC sputtering generally involves applying a direct current to a metal target (i.e., the cathode) positioned near the substrate (i.e., the anode) within a sputtering chamber to form a direct-current discharge. As stated, the sputtering chamber can have a reactive atmosphere (e.g., an oxygen atmosphere, nitrogen atmosphere, fluorine atmosphere) that forms a plasma field between the metal target and the substrate. Other inert gases (e.g., argon, etc.) may also be present. The pressure of the reactive atmosphere can be between about 1 mTorr and about 20 mTorr for magnetron sputtering. The pressure can be even higher for diode sputtering (e.g., from about 25 mTorr to about 100 mTorr). When metal atoms are released from the target upon application of the voltage, the metal atoms deposit onto the surface of the substrate. For example, when the atmosphere contains oxygen, the metal atoms released from the metal target can form a metallic oxide layer on the substrate. The current applied to the source material can vary depending on the size of the source material, size of the sputtering chamber, amount of surface area of substrate, and other variables. In some embodiments, the current applied can be from about 2 amps to about 20 amps. Conversely, RF sputtering involves exciting a capacitive discharge by applying an alternating-current (AC) or radio-frequency (RF) signal between the target (e.g., a ceramic source material) and the substrate. The sputtering chamber can have an inert atmosphere (e.g., an argon atmosphere) which may or may not contain reactive species (e.g., oxygen, nitrogen, etc.) having a pressure between about 1 mTorr and about 20 mTorr for magnetron sputtering. Again, the pressure can be even higher for diode sputtering (e.g., from about 25 mTorr to about 100 mTorr).

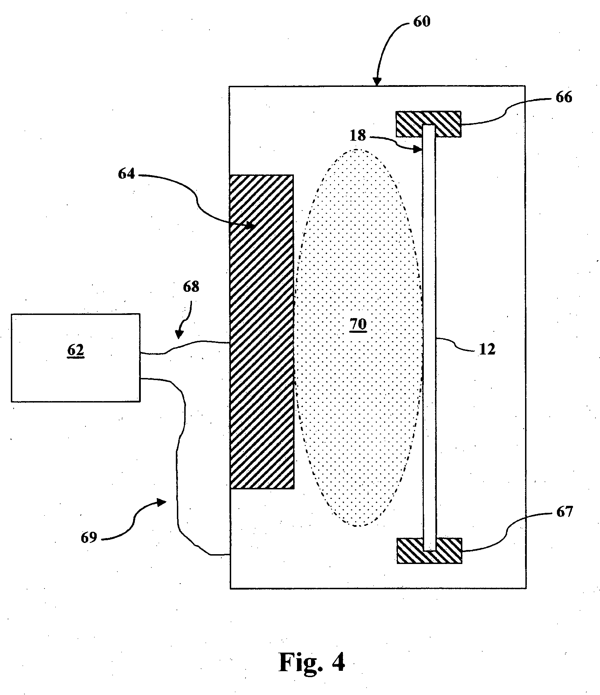

Fig. 4 shows a general schematic as a cross-sectional view of an exemplary DC sputtering chamber 60 according to one embodiment of the present invention. A DC power source 62 is configured to control and supply DC power to the chamber 60. As shown, the DC power source applies a voltage to the cathode 64 to create a voltage potential between the cathode 64 and an anode formed by the chamber wall, such that the substrate is in between the cathode and anode. The glass substrate 12 is held between top support 66 and bottom support 67. Power is delivered and returned via wires 68 and 69, respectively. Generally, the glass substrate 12 is positioned within the sputtering chamber 60 such that the cadmium sulfide layer 18 is formed on the surface facing the cathode 64, and generally on the TCO layer 14 and RTB layer 16 (not shown) as discussed below. In certain embodiments, the substrate can be heated to a sputtering temperature. For instance, the substrate can be heated to the sputtering temperature via ovens prior to entering the sputtering chamber and/or via heaters positioned within the sputtering chamber.

A plasma field 70 is created once the sputtering atmosphere is ignited, and is sustained in response to the voltage potential between the cathode 64 and the chamber wall acting as an anode. The voltage potential causes the plasma ions within the plasma field 70 to accelerate toward the cathode 64, causing atoms from the cathode 64 to be ejected toward the surface on the glass substrate 12. As such, the cathode 64 can be referred to as a "target" and acts as the source material for the formation of the cadmium sulfide layer 18 on the surface of the glass substrate 12 facing the cathode 64. To form the cadmium sulfide layer, the cathode 64 can be a metal alloy target, such as of cadmium sulfide. Additionally, in some embodiments, a plurality of cathodes 64 can be utilized. A plurality of cathodes 64 can be particularly useful to form a layer including several types of materials (e.g., co-sputtering). Since the sputtering atmosphere contains an inorganic fluorine source gas, fluorine atoms of the plasma field 70 can react with the ejected target atoms to form a cadmium sulfide layer 18 that includes fluorine.

Although only a single DC power source 62 is shown, the voltage potential can be realized through the use of multiple power sources coupled together. Additionally, the exemplary sputtering chamber 60 is shown having a vertical orientation, although any other configuration can be utilized. After exiting the sputtering chamber 60, the substrate 12 can enter an adjacent annealing oven (not shown) to begin the annealing process.

The inorganic fluorine source gas can be any suitable inorganic fluorine source gas that is a gas at the sputtering conditions and can add fluorine atoms to the cadmium sulfide layer. Suitable inorganic fluorine source gases include, but are not limited to, sulfur hexafluoride, sulfur tetrafluoride, nitrogen trifluoride, nitrosyl fluoride, bromine trifluoride, bromine pentafluoride, chlorine pentafluoride, chlorine trifluoride, chlorine monofluoride, iodine pentafluoride, and mixtures thereof.

One particularly suitable inorganic fluorine source gas is nitrogen trifluoride, which can readily dissociate to contribute fluorine to the cadmium sulfide layer. Additionally, the by-product of nitrogen gas and/or metal nitride can be easily pumped away in a vacuum system.

Another particularly suitable inorganic fluorine source gas is sulfur hexafluoride, which can also readily dissociate to contribute fluorine to the cadmium sulfide layer. This gas may also contribute excess sulfur to the deposition chamber, which may or may not be desired since it could potentially alter the stoichiometry of the cadmium verses sulfur in the cadmium sulfide layer.

Not all fluorinating gases, however, may be suitable as a fluorine source gas. For example, elemental fluorine gas (F₂) may be too corrosive for use in the sputtering chamber, especially in a commercial scale manufacturing setting. Organic fluorine source gases, as another example, may produce organic residues that could contaminate the cadmium sulfide layer during its formation. For instance, fluoromethane (CH₃F) gas can produce dimethyl cadmium (Cd(CH₃)₂ in the sputtering atmosphere, which could consume cadmium during the sputtering process decreasing the sputtering rate and potentially deposit organic materials in the cadmium sulfide layer adversely affecting the performance of the resulting photovoltaic device. Thus, in one particular embodiment, the sputtering atmosphere can be substantially free from any organic materials (e.g., less than about 0.1% by volume organic materials), including fluoromethane gas.

The fluorine doped cadmium sulfide layer can be utilized in the formation of any film stack that utilizes a cadmium sulfide layer. For example, the fluorine doped cadmium sulfide layer can be used during the formation of any cadmium telluride device that utilizes a cadmium telluride layer, such as in the cadmium telluride thin film photovoltaic device disclosed in U.S. Publication No. 2009/0194165 of Murphy et al. titled "Ultra-high Current Density Cadmium Telluride Photovoltaic Modules."

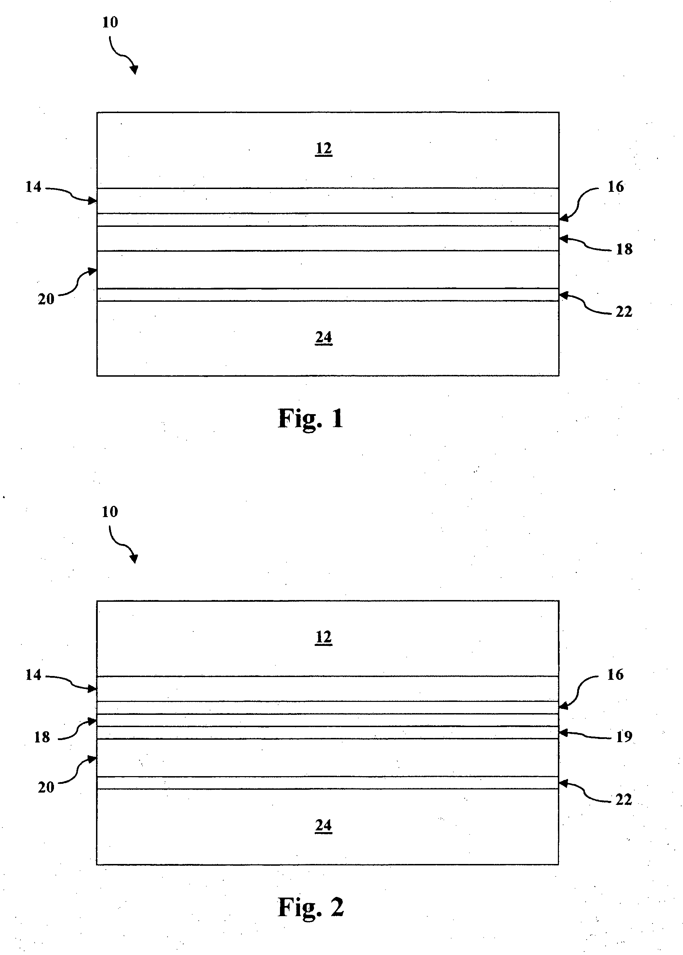

Fig. 1 represents cadmium telluride thin film photovoltaic devices 10 that can be formed according to methods described herein. The exemplary device 10 of Fig. 1 includes a top sheet of glass 12 employed as the substrate. In this embodiment, the glass 12 can be referred to as a "superstrate," as it is the substrate on which the subsequent layers are formed even though it faces upward to the radiation source (e.g., the sun) when the cadmium telluride thin film photovoltaic device 10 is in used. The top sheet of glass 12 can be a high-transmission glass (e.g., high transmission borosilicate glass), low-iron float glass, or other highly transparent glass material. The glass is generally thick enough to provide support for the subsequent film layers (e.g., from about 0.5 mm to about 10 mm thick), and is substantially flat to provide a good surface for forming the subsequent film layers. In one embodiment, the glass 12 can be a low iron float glass containing less than about 0.015% by weight iron (Fe), and may have a transmissiveness of about 0.9 or greater in the spectrum of interest (e.g., wavelengths from about 300 nm to about 900 nm). In another embodiment, borosilicate glass may be utilized so as to better withstand high temperature processing.

A transparent conductive oxide (TCO) layer 14 is shown on the glass 12 of the exemplary device 10 of Fig. 1. The TCO layer 14 allows light to pass through with minimal absorption while also allowing electric current produced by the device 10 to travel sideways to opaque metal conductors (not shown). For instance, the TCO layer 14 can have a sheet resistance less than about 30 ohm per square, such as from about 4 ohm per square to about 20 ohm per square (e.g., from about 8 ohm per square to about 15 ohm per square). The TCO layer 14 generally includes at least one conductive oxide, such as tin oxide, zinc oxide, or indium tin oxide, or mixtures thereof. Additionally, the TCO layer 14 can include other conductive, transparent materials. The TCO layer 14 can also include zinc stannate and/or cadmium stannate.

The TCO layer 14 can be formed by sputtering, chemical vapor deposition, spray pryolysis, or any other suitable deposition method. In one particular embodiment, the TCO layer 14 can be formed by sputtering (e.g., DC sputtering or RF sputtering) on the glass 12. For example, a cadmium stannate layer can be formed by sputtering a hot-pressed target containing stoichiometric amounts of SnO₂ and CdO onto the glass 12 in a ratio of about 1 to about 2. The cadmium stannate can alternatively be prepared by using cadmium acetate and tin (II) chloride precursors by spray pyrolysis. In certain embodiments, the TCO layer 14 can have a thickness between about 0.1 µm and about 1 µm, for example from about 0.1 µm to about 0.5 µm, such as from about 0.25 µm to about 0.35 µm. Suitable flat glass substrates having a TCO layer 14 formed on the superstrate surface can be purchased commercially from various glass manufactures and suppliers. For example, a particularly suitable glass 12 including a TCO layer 14 includes TEC 15 glass commercially available under the name TEC 15 TCO from Pilkington North America Inc. (Toledo, Ohio), which includes a TCO layer having a sheet resistance of 15 ohms per square.

A resistive transparent buffer layer 16 (RTB layer) is shown on the TCO layer 14 on the exemplary cadmium telluride thin film photovoltaic device 10. The RTB layer 16 is generally more resistive than the TCO layer 14 and can help protect the device 10 from chemical interactions between the TCO layer 14 and the subsequent layers during processing of the device 10. For example, in certain embodiments, the RTB layer 16 can have a sheet resistance that is greater than about 1000 ohms per square, such as from about 10 kOhms per square to about 1000 MOhms per square. The RTB layer 16 can also have a wide optical bandgap (e.g., greater than about 2.5 eV, such as from about 2.7 eV to about 3.0 eV).

Without wishing to be bound by a particular theory, it is believed that the presence of the RTB layer 16 between the TCO layer 14 and the cadmium sulfide layer 18 can allow for a relatively thin cadmium sulfide layer 18 to be included in the device 10 by reducing the possibility of interface defects (i.e., "pinholes" in the cadmium sulfide layer 18) creating shunts between the TCO layer 14 and the cadmium telluride layer 22. Thus, it is believed that the RTB layer 16 allows for improved adhesion and/or interaction between the TCO layer 14 and the cadmium telluride layer 22, thereby allowing a relatively thin cadmium sulfide layer 18 to be formed thereon without significant adverse effects that would otherwise result from such a relatively thin cadmium sulfide layer 18 formed directly on the TCO layer 14.

The RTB layer 16 can include, for instance, a combination of zinc oxide (ZnO) and tin oxide (SnO₂) which can be referred to as a zinc tin oxide layer ("ZTO"). In one particular embodiment, the RTB layer 16 can include more tin oxide than zinc oxide. For example, the RTB layer 16 can have a composition with a stoichiometric ratio of ZnO/SnO₂ between about 0.25 and about 3, such as in about an one to two (1:2) stoichiometric ratio of tin oxide to zinc oxide. The RTB layer 16 can be formed by sputtering, chemical vapor deposition, spraying pryolysis, or any other suitable deposition method. In one particular embodiment, the RTB layer 16 can be formed by sputtering (e.g. DC sputtering or RF sputtering) on the TCO layer 14 (as discussed below in greater detail with respect to the deposition of the cadmium sulfide layer 18). For example, the RTB layer 16 can be deposited using a DC sputtering method by applying a DC current to a metallic source material (e.g., elemental zinc, elemental tin, or a mixture thereof) and sputtering the metallic source material onto the TCO layer 14 in the presence of an oxidizing atmosphere (e.g., O₂ gas). When the oxidizing atmosphere includes oxygen gas (i.e., O₂), the atmosphere can be greater than about 95% pure oxygen, such as greater than about 99%.

In certain embodiments, the RTB layer 16 can have a thickness between about 0.075 µm and about 1 µm, for example from about 0.1 µm to about 0.5 µm. In particular embodiments, the RTB layer 16 can have a thickness between about 0.08 µm and about 0.2 µm, for example from about 0.1 µm to about 0.15 µm.

A cadmium sulfide layer 18 including fluorine is shown on RTB layer 16 of the exemplary device 10 of Fig. 1. The cadmium sulfide layer 18 is a n-type layer that generally includes cadmium sulfide (CdS) and fluorine, but may also include other materials, such as zinc sulfide, cadmium zinc sulfide, etc., and mixtures thereof as well as dopants and other impurities. In one particular embodiment, the cadmium sulfide layer may include oxygen up to about 25% by atomic percentage, for example from about 5% to about 20% by atomic percentage. The cadmium sulfide layer 18 can have a wide band gap (e.g., from about 2.25 eV to about 2.5 eV, such as about 2.4 eV) in order to allow most radiation energy (e.g., solar radiation) to pass. As such, the cadmium sulfide layer 18 is considered a transparent layer on the device 10.

The cadmium sulfide layer 18 can be formed by sputtering, chemical vapor deposition, chemical bath deposition, and other suitable deposition methods. In one particular embodiment, the cadmium sulfide layer 18 can be formed by sputtering (e.g., radio frequency (RF) sputtering) on the resistive transparent layer 16.

Due to the presence of the resistive transparent layer 16, the cadmium sulfide layer 18 can have a thickness that is less than about 0.1 µm, such as between about 10 nm and about 100 nm, such as from about 50 nm to about 80 nm, with a minimal presence of pinholes between the resistive transparent layer 16 and the cadmium sulfide layer 18. Additionally, a cadmium sulfide layer 18 having a thickness less than about 0.1 µm reduces any absorption of radiation energy by the cadmium sulfide layer 18, effectively increasing the amount of radiation energy reaching the underlying cadmium telluride layer 22.

Fig. 2 shows an exemplary device 10 having a second cadmium sulfide layer 19 on the cadmium sulfide layer 18 including fluorine. The second cadmium sulfide layer 19 is included between the cadmium sulfide layer 18 including fluorine and the cadmium telluride layer 20 to improve the junction formed between the cadmium sulfide layer 18 including fluorine and the cadmium telluride layer 20.

The second cadmium sulfide layer 19 is substantially free from fluorine to inhibit the diffusion of fluorine into the cadmium telluride layer 20 from the cadmium sulfide layer 18 including fluorine. As used herein, the term "substantially free" means no more than an insignificant trace amount present and encompasses completely free (e.g., 0 molar % up to 0.0001 molar %). For instance, the cadmium sulfide layer 18 including fluorine can be sputtered from a first sputtering atmosphere including fluorine. Then, the second cadmium sulfide layer 19 can be sputtered in a second sputtering atmosphere substantially free from fluorine. For example, the second cadmium sulfide layer 19 can be sputtered from a metal target of cadmium sulfide in a sputtering atmosphere containing an inert gas (e.g., argon) without any fluorine present, such as consisting essentially of an inert gas (e.g., argon) or inert gasses. In one embodiment, the sputtering atmosphere can consist of argon for sputtering the second cadmium sulfide layer 19 on the cadmium sulfide layer 18 including fluorine.

When present, the second cadmium sulfide layer 19 can have a thickness of about 10 nm to about 100 nm (e.g., about 10 nm to about 50 nm), while the cadmium sulfide layer 18 including fluorine has a thickness of about 10 nm to about 100 nm (e.g., about 10 nm to about 50 nm).

In another embodiment, the second cadmium sulfide layer 19 can be composed from a plurality of layers, where each layer has a decreasing amount of fluorine in a direction away from the cadmium sulfide layer 18 including fluorine and toward the cadmium telluride layer 20. For example, Fig. 4 another an exemplary embodiment of a second cadmium sulfide layer 19 that includes a plurality of layers of decreasing fluorine content (layers 1-5, respectively) formed step-wise to collectively define the second cadmium sulfide layer 19. Each individual layer 1-5 has a decreasing fluorine content, such that layer 2 has less fluorine content than layer 1, layer 3 has less fluorine content than layer 2, layer 4 has less fluorine content than layer 3, and layer 5 has less fluorine content than layer 4. For instance, layer 1 can have an fluorine content of about 4 molar % to about 5 molar %; layer 2 can have an fluorine content of about 3 molar % to about 4 molar %; layer 3 can have an fluorine content of about 2 molar % to about 3 molar %; layer 4 can have an fluorine content of about 1 molar % to about 2 molar %; and, layer 5 can be substantially free from fluorine. Although the exemplary step-wise graded second cadmium sulfide layer 19 has five layers 1-5, any number of step-wise layers can be used to form the graded second cadmium sulfide layer 19. Additionally, each of the layers 1-5 can be formed of varying thickness, such as from about 1 nm to about 50 nm in thickness. In certain embodiments, the thickness of each of the layers 1-5 can be from about 5 nm to about 50 nm, for example from about 10 nm to about 30 nm. In one embodiment, each of the layers 1-5 can have substantially the same thickness.

Such a graded second cadmium sulfide layer 19 can be achieved by reducing the amount of fluorine in the sputtering atmosphere during sputtering in a single chamber or in a series of sequential chambers.

A cadmium telluride layer 20 is shown on the cadmium sulfide layer 18 in the exemplary cadmium telluride thin film photovoltaic device 10 of Fig. 1. The cadmium telluride layer 20 is a p-type layer that generally includes cadmium telluride (CdTe) but may also include other materials. As the p-type layer of device 10, the cadmium telluride layer 20 is the photovoltaic layer that interacts with the cadmium sulfide layer 18 (i.e., the n-type layer) to produce current from the absorption of radiation energy by absorbing the majority of the radiation energy passing into the device 10 due to its high absorption coefficient and creating electron-hole pairs. For example, the cadmium telluride layer 20 can generally be formed from cadmium telluride and can have a bandgap tailored to absorb radiation energy (e.g., from about 1.4 eV to about 1.5 eV, such as about 1.45 eV) to create the maximum number of electron-hole pairs with the highest electrical potential (voltage) upon absorption of the radiation energy. Electrons may travel from the p-type side (i.e., the cadmium telluride layer 20) across the junction to the n-type side (i.e., the cadmium sulfide layer 18) and, conversely, holes may pass from the n-type side to the p-type side. Thus, the p-n junction formed between the cadmium sulfide layer 18 and the cadmium telluride layer 20 forms a diode in which the charge imbalance leads to the creation of an electric field spanning the p-n junction. Conventional current is allowed to flow in only one direction and separates the light induced electron-hole pairs.

The cadmium telluride layer 20 can be formed by any known process, such as vapor transport deposition, chemical vapor deposition (CVD), spray pyrolysis, electrodeposition, sputtering, close-space sublimation (CSS), etc. In one particular embodiment, the cadmium sulfide layer 18 is deposited by a sputtering and the cadmium telluride layer 20 is deposited by close-space sublimation. In particular embodiments, the cadmium telluride layer 20 can have a thickness between about 0.1 µm and about 10 µm, such as from about 1 µm and about 5 µm. In one particular embodiment, the cadmium telluride layer 20 can have a thickness between about 2 µm and about 4 µm, such as about 3 µm.

A series of post-forming treatments can be applied to the exposed surface of the cadmium telluride layer 20. These treatments can tailor the functionality of the cadmium telluride layer 20 and prepare its surface for subsequent adhesion to the back contact layer(s) 22. For example, the cadmium telluride layer 20 can be annealed at elevated temperatures (e.g., from about 350° C to about 500° C, such as from about 375° C to about 424° C) for a sufficient time (e.g., from about 1 to about 10 minutes) to create a quality p-type layer of cadmium telluride. Without wishing to be bound by theory, it is believed that annealing the cadmium telluride layer 20 (and the device 10) converts the normally lightly p-type doped, or even n-type doped cadmium telluride layer 20 to a more strongly p-type cadmium telluride layer 20 having a relatively low resistivity. Additionally, the cadmium telluride layer 20 can recrystallize and undergo grain growth during annealing.

Annealing the cadmium telluride layer 20 can be carried out in the presence of cadmium chloride in order to dope the cadmium telluride layer 20 with chloride ions. For example, the cadmium telluride layer 20 can be washed with an aqueous solution containing cadmium chloride and then annealed at the elevated temperature.

In one particular embodiment, after annealing the cadmium telluride layer 20 in the presence of cadmium chloride, the surface can be washed to remove any cadmium oxide formed on the surface. This surface preparation can leave a Te-rich surface on the cadmium telluride layer 20 by removing oxides from the surface, such as CdO, CdTeO₃, CdTe₂O₅, etc. For instance, the surface can be washed with a suitable solvent (e.g., ethylenediamine also known as 1,2 diaminoethane or "DAE") to remove any cadmium oxide from the surface.

Additionally, copper can be added to the cadmium telluride layer 20. Along with a suitable etch, the addition of copper to the cadmium telluride layer 20 can form a surface of copper-telluride on the cadmium telluride layer 20 in order to obtain a low-resistance electrical contact between the cadmium telluride layer 20 (i.e., the p-type layer) and the back contact layer(s). Specifically, the addition of copper can create a surface layer of cuprous telluride (Cu₂Te) between the cadmium telluride layer 20 and the back contact layer 22. Thus, the Te-rich surface of the cadmium telluride layer 20 can enhance the collection of current created by the device through lower resistivity between the cadmium telluride layer 20 and the back contact layer 22.

Copper can be applied to the exposed surface of the cadmium telluride layer 20 by any process. For example, copper can be sprayed or washed on the surface of the cadmium telluride layer 20 in a solution with a suitable solvent (e.g., methanol, water, or the like, or combinations thereof) followed by annealing. In particular embodiments, the copper may be supplied in the solution in the form of copper chloride, copper iodide, or copper acetate. The annealing temperature is sufficient to allow diffusion of the copper ions into the cadmium telluride layer 20, such as from about 125° C to about 300° C (e.g. from about 150° C to about 200° C) for about 5 minutes to about 30 minutes, such as from about 10 to about 25 minutes.

A back contact layer 22 is shown on the cadmium telluride layer 20. The back contact layer 22 generally serves as the back electrical contact, in relation to the opposite, TCO layer 14 serving as the front electrical contact. The back contact layer 22 can be formed on, and in one embodiment is in direct contact with, the cadmium telluride layer 20. The back contact layer 22 is suitably made from one or more highly conductive materials, such as elemental nickel, chromium, copper, tin, aluminum, gold, silver, technetium or alloys or mixtures thereof. Additionally, the back contact layer 22 can be a single layer or can be a plurality of layers. In one particular embodiment, the back contact layer 22 can include graphite, such as a layer of carbon deposited on the p-layer followed by one or more layers of metal, such as the metals described above. The back contact layer 22, if made of or comprising one or more metals, is suitably applied by a technique such as sputtering or metal evaporation. If it is made from a graphite and polymer blend, or from a carbon paste, the blend or paste is applied to the semiconductor device by any suitable method for spreading the blend or paste, such as screen printing, spraying or by a "doctor" blade. After the application of the graphite blend or carbon paste, the device can be heated to convert the blend or paste into the conductive back contact layer. A carbon layer, if used, can be from about 0.1 µm to about 10 µm in thickness, for example from about 1 µm to about 5 µm. A metal layer of the back contact, if used for or as part of the back contact layer 22, can be from about 0.1 µm to about 1.5 µm in thickness.

The encapsulating glass 24 is also shown in the exemplary cadmium telluride thin film photovoltaic device 10 of Fig. 1.

Other components (not shown) can be included in the exemplary device 10, such as bus bars, external wiring, laser etches, etc. For example, when the device 10 forms a photovoltaic cell of a photovoltaic module, a plurality of photovoltaic cells can be connected in series in order to achieve a desired voltage, such as through an electrical wiring connection. Each end of the series connected cells can be attached to a suitable conductor such as a wire or bus bar, to direct the photovoltaically generated current to convenient locations for connection to a device or other system using the generated electric. A convenient means for achieving such series connections is to laser scribe the device to divide the device into a series of cells connected by interconnects. In one particular embodiment, for instance, a laser can be used to scribe the deposited layers of the semiconductor device to divide the device into a plurality of series connected cells.

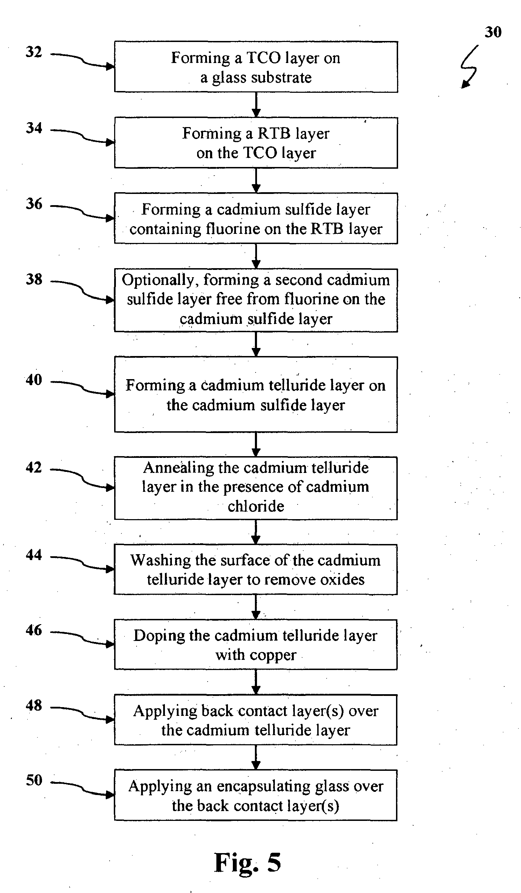

Fig. 5 shows a flow diagram of an exemplary method 30 of manufacturing a photovoltaic device according to one embodiment of the present invention. According to the exemplary method 30, a TCO layer is formed on a glass substrate at 32. At 34, a resistive transparent buffer layer is formed on the TCO layer. A cadmium sulfide layer containing fluorine is formed on the resistive transparent buffer layer at 36. Optionally, a second cadmium sulfide layer substantially free from fluorine is formed on the cadmium sulfide layer including oxygen at 38. A cadmium telluride layer is formed on the cadmium sulfide layer at 40. The cadmium telluride layer can be annealed in the presence of cadmium chloride at 42, and washed to remove oxides formed on the surface at 44. The cadmium telluride layer can be doped with copper at 46. At 48, back contact layer(s) can be applied over the cadmium telluride layer, and an encapsulating glass can be applied over the back contact layer at 50.

One of ordinary skill in the art should recognize that other processing and/or treatments can be included in the method 30. For instance, the method may also include laser scribing to form electrically isolated photovoltaic cells in the device. These electrically isolated photovoltaic cells can then be connected in series to form a photovoltaic module. Also, electrical wires can be connected to positive and negative terminals of the photovoltaic module to provide lead wires to harness electrical current produced by the photovoltaic module.

This written description uses examples to disclose the invention, including the best mode, and also to enable any person skilled in the art to practice the invention, including making and using any devices or systems and performing any incorporated methods. The patentable scope of the invention is defmed by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A method of doping a cadmium sulfide thin film layer 18 with fluorine, the method comprising:
sputtering a cadmium sulfide layer 18 on a substrate 12 in a sputtering atmosphere comprising an inorganic fluorine source gas, wherein the sputtering atmosphere is free from organic materials.

2. The method as in claim 1, wherein the inorganic fluorine source gas comprises sulfur hexafluoride, sulfur tetrafluoride, nitrogen trifluoride, nitrosyl fluoride, bromine trifluoride, bromine pentafluoride, chlorine pentafluoride, chlorine trifluoride, chlorine monofluoride, iodine pentafluoride, or mixtures thereof.

3. The method as in claim 1 or 2, wherein the inorganic fluorine source gas comprises sulfur hexafluoride.

4. The method as in claim 1 or 2, wherein the inorganic fluorine source gas comprises nitrogen trifluoride.

5. The method as in any preceding claim, wherein the inorganic fluorine source gas is substantially free from elemental fluorine gas.

6. The method as in any preceding claim, wherein the sputtering atmosphere comprises greater than 0% to about 15% by volume of the inorganic fluorine source gas, preferably about 1% to about 10% by volume of the inorganic fluorine source gas.

7. The method as in any preceding claim, wherein the sputtering atmosphere further comprises oxygen from greater than 0% to about 15% by volume.

8. The method as in any preceding claim, further comprising:
sputtering a second cadmium sulfide layer 19 on the cadmium sulfide layer 18, such that the second cadmium sulfide layer is positioned between the cadmium sulfide layer and the cadmium telluride layer, wherein the second cadmium sulfide layer 19 is sputtered on the cadmium sulfide layer 18 in a second sputtering atmosphere that is free from fluorine.

9. The method as in any preceding claim, wherein the amount of fluorine in the sputtering atmosphere is decreased during sputtering such that the cadmium sulfide layer 18 has a decreasing concentration of fluorine.

10. A cadmium telluride based thin film photovoltaic device 10, the device 10 comprising:
a substrate 12;
a transparent conductive oxide layer 14 on the substrate 12;
a cadmium sulfide layer 18 on the transparent conductive oxide layer 14, wherein the cadmium sulfide layer 18 comprises cadmium sulfide doped with fluorine;
a second cadmium sulfide layer 19 on the cadmium sulfide layer 18, wherein the second cadmium sulfide layer 19 is free from fluorine; and
a cadmium telluride layer 20 on the second cadmium sulfide layer 19.

11. The device 10 as in claim 10, wherein the second cadmium sulfide layer 19 consists of cadmium sulfide.

12. The device as in claim 10 or claim 11, wherein the cadmium sulfide layer 18 comprises fluorine in a graded concentration that decreases in a direction from the resistive transparent conductive layer 16 to the cadmium telluride layer 20.

## Patentansprüche

1. Verfahren zum Dotieren einer Cadmiumsulfid-Dünnschicht 18 mit Fluor, wobei das Verfahren Folgendes umfasst:
Sputtern einer Cadmiumsulfidschicht 18 auf ein Substrat 12 in einer Sputter-Atmosphäre, die ein anorganisches Gas umfasst, welches eine Fluorquelle darstellt, wobei die Sputter-Atmosphäre frei von organischen Stoffen ist.

2. Verfahren nach Anspruch 1, wobei das anorganische Gas, welches eine Fluorquelle darstellt, Schwefelhexafluorid, Schwefeltetrafluorid, Stickstofftrifluorid, Nitrosylfluorid, Bromtrifluorid, Brompentafluorid, Chlorpentafluorid, Chlortrifluorid, Chlormonofluorid, lodpentafluorid oder Mischungen davon umfasst.

3. Verfahren nach Anspruch 1 oder 2, wobei das anorganische Gas, welches eine Fluorquelle darstellt, Schwefelhexafluorid umfasst.

4. Verfahren nach Anspruch 1 oder 2, wobei das anorganische Gas, welches eine Fluorquelle darstellt, Stickstofftrifluorid umfasst.

5. Verfahren nach einem beliebigen der vorhergehenden Ansprüche, wobei das anorganische Gas, welches eine Fluorquelle darstellt, im Wesentlichen frei von elementarem Fluorgas ist.

6. Verfahren nach einem beliebigen der vorhergehenden Ansprüche, wobei die Sputter-Atmosphäre mehr als 0 % bis ungefähr 15 % nach Volumen an dem anorganischen Gas, welches eine Fluorquelle darstellt, vorzugsweise ungefähr 1 % bis ungefähr 10 % nach Volumen an dem anorganischen Gas, welches eine Fluorquelle darstellt, umfasst.

7. Verfahren nach einem beliebigen der vorhergehenden Ansprüche, wobei die Sputter-Atmosphäre mehr als 0 % bis ungefähr 15 % nach Volumen an Sauerstoff umfasst.

8. Verfahren nach einem beliebigen der vorhergehenden Ansprüche, welches weiterhin Folgendes umfasst:
Sputtern einer zweiten Cadmiumsulfidschicht 19 auf die Cadmiumsulfidschicht 18, derart, dass die zweite Cadmiumsulfidschicht zwischen der Cadmiumsulfidschicht und der Cadmiumtelluridschicht angeordnet ist, wobei die zweite Cadmiumsulfidschicht 19 in einer zweiten Sputter-Atmosphäre, welche frei von Fluor ist, auf die Cadmiumsulfidschicht 18 gesputtert wird.

9. Verfahren nach einem der vorhergehenden Ansprüche, wobei die Menge an Fluor in der Sputter-Atmosphäre während des Sputtern derart verringert wird, dass die Cadmiumsulfidschicht 18 eine abnehmende Konzentration an Fluor aufweist.

10. Cadmiumtelluridbasierte photovoltaische Dünnschichtvorrichtung 10, wobei die Vorrichtung 10 Folgendes umfasst:
ein Substrat 12;
eine transparente leitfähige Oxidschicht 14 auf dem Substrat 12;
eine Cadmiumsulfidschicht 18 auf der transparenten leitfähigen Oxidschicht 14,
wobei die Cadmiumsulfidschicht 18 Cadmiumsulfid umfasst, das mit Fluor dotiert ist;
eine zweite Cadmiumsulfidschicht 19 auf der Cadmiumsulfidschicht 18, wobei die zweite Cadmiumsulfidschicht 19 frei von Fluor ist; und
eine Cadmiumtelluridschicht 20 auf der zweiten Cadmiumsulfidschicht 19.

11. Vorrichtung nach Anspruch 10, wobei die zweite Cadmiumsulfidschicht 19 aus Cadmiumsulfid besteht.

12. Vorrichtung nach Anspruch 10 oder Anspruch 11, wobei die Cadmiumsulfidschicht 18 Fluor in einer abgestuften Konzentration umfasst, welche von der transparenten ohmsch leitfähigen Schicht 16 zur Cadmiumtelluridschicht 20 hin abnimmt.

## Revendications

1. Procédé de dopage d'une couche (18) de film mince de sulfure de cadmium avec du fluor, ce procédé comprenant :
la pulvérisation d'une couche de sulfure de cadmium 18 sur un substrat 12 sous une atmosphère de pulvérisation comprenant un gaz source de fluor inorganique, dans lequel l'atmosphère de pulvérisation est exempte de matières organiques.

2. Procédé selon la revendication 1, dans lequel le gaz source de fluor inorganique comprend de l'hexafluorure de soufre, du tétrafluorure de soufre, du trifluorure d'azote, du fluorure de nitrosyle, du trifluorure de brome, du pentafluorure de brome, du pentafluorure de chlore, du trifluorure de chlore, du monofluorure de chlore, du pentafluorure d'iode, ou des mélanges de ceux-ci.

3. Procédé selon la revendication 1 ou 2, dans lequel le gaz source de fluor inorganique comprend de l'hexafluorure de soufre.

4. Procédé selon la revendication 1 ou 2, dans lequel le gaz source de fluor inorganique comprend du trifluorure d'azote.

5. Procédé selon l'une quelconque des revendications précédentes, dans lequel le gaz source de fluor inorganique est sensiblement exempt de fluor gazeux élémentaire.

6. Procédé selon l'une quelconque des revendications précédentes, dans lequel l'atmosphère de pulvérisation comprend plus de 0 % jusqu'à environ 15 % en volume du gaz source de fluor inorganique, de préférence environ 1 % jusqu'à environ 10 % en volume du gaz source de fluor inorganique.

7. Procédé selon l'une quelconque des revendications précédentes, dans lequel l'atmosphère de pulvérisation comprend en outre de l'oxygène à plus de 0 % jusqu'à environ 15 % en volume.

8. Procédé selon l'une quelconque des revendications précédentes, comprenant en outre :
la pulvérisation d'une seconde couche de sulfure de cadmium 19 sur la couche de sulfure de cadmium 18, de telle manière que la seconde couche de sulfure de cadmium se trouve placée entre la couche de sulfure de cadmium et la couche de tellurure de cadmium, dans lequel la seconde couche de sulfure de cadmium 19 est pulvérisée sur la couche de sulfure de cadmium 18 sous une seconde atmosphère de pulvérisation qui est exempte de fluor.

9. Procédé selon l'une quelconque des revendications précédentes, dans lequel la quantité de fluor contenue dans l'atmosphère de pulvérisation décroît pendant la pulvérisation, de telle manière que la couche de sulfure de cadmium 18 présente une concentration en fluor décroissante.

10. Dispositif photovoltaïque à couche mince à base de tellurure de cadmium 10, ce dispositif 10 comprenant :
un substrat 12 ;
une couche d'oxyde conductrice transparente 14 sur le substrat 12 ;
une couche de sulfure de cadmium 18 sur la couche d'oxyde conductrice transparente 14, dans laquelle la couche de sulfure de cadmium 18 comprend du sulfure de cadmium dopé au fluor ;
une seconde couche de sulfure de cadmium 19 sur la couche de sulfure de cadmium 18, dans laquelle la seconde couche de sulfure de cadmium 19 est exempte de fluor ; et
une couche de tellurure de cadmium 20 sur la seconde couche de sulfure de cadmium.

11. Dispositif selon la revendication 10, dans lequel la seconde couche de sulfure de cadmium 19 est composée de sulfure de cadmium 19.

12. Dispositif selon la revendication 10 ou la revendication 11, dans lequel la couche de sulfure de cadmium 18 comprend du fluor en concentration calibrée qui décroît dans une direction allant de la couche conductrice transparente résistante 16 à la couche de tellurure de cadmium 20.
